Europäisches Patentamt

European Patent Office

Office européen des brevets

(11) Publication number: **0 129 731**
**A1**

(12) **EUROPEAN PATENT APPLICATION**

(21) Application number: **84106071.8**

(22) Date of filing: **28.05.84**

(51) Int. Cl.⁴: **H 05 K 13/00**
**H 05 K 13/02**

(30) Priority: **15.06.83 US 504765**

(43) Date of publication of application:
**02.01.85 Bulletin 85/1**

(84) Designated Contracting States:
**CH DE FR GB IT LI NL**

(71) Applicant: **THE PERKIN-ELMER CORPORATION**
**Main Avenue**
**Norwalk Connecticut 06856(US)**

(72) Inventor: **Engelbrecht, Orest**
**66 Nature View Trail**
**Bethel Connecticut 06801(US)**

(72) Inventor: **Byers, William**
**976 Wheelers Farm Road**
**Milford Connecticut 06460(US)**

(74) Representative: **Patentanwälte Grünecker, Dr.**
**Kinkeldey, Dr. Stockmair, Dr. Schumann, Jakob, Dr.**
**Bezold, Meister, Hilgers, Dr. Meyer-Plath**
**Maximilianstrasse 58**
**D-8000 München 22(DE)**

(54) Wafer handling system.

(57) A wafer handling system for transporting wafers from an input cassette to an aligner, a work station and thence to a storage cassette. A first shuttle selects a wafer from the input cassette and transports it to an alignment station where the wafer is lifted from the first shuttle, precisely aligned and deposited back on the first shuttle without loss of alignment. The first shuttle then transports the wafer to a work station where its is deposited without loss of alignment. A second shuttle retrieves the wafer from the work station and transports it to the storage cassette. Throughout the wafer handling cycle the wafers are touched only on their unsensitized surface.

FIG. 1

GRI                                           \JR
DR.                                           [ER

MAXIMILIANSTR. 58 · 8000 MÜNCHEN 22

WAFER HANDLING SYSTEM


## BACKGROUND OF THE INVENTION

In the fabrication of integrated circuits the
silicon wafers on which circuits are formed must undergo a
large number of processing steps.  For example, each wafer
must be coated, exposed, developed, etched and recoated
many times as the integrated circuits on the wafers are
built up layer by layer.  Such a large number of
processing steps require that the wafers be constantly
handled.  For example, in the exposure step a wafer must
be aligned prior to exposure.  Efficiency demands that the
exposure process be automated.  Thus, wafers stored in an
input cassette are automatically transported on a one by
one basis to an alignment station where they are aligned
in accordance with a known reference.  After alignment the
wafer is automatically transported to the exposure
station.  After exposure the wafer is automatically
retrieved and placed in a storage cassette.  This process
is continued until each wafer in the input cassette has
been aligned, exposed and stored in the storage cassette.
Other processing steps, e.g., the etching step also
require the repetitive handling of wafers.

Prior systems for automatically carrying out one
or more wafer processing steps employ air tracks created
by air jets wherein the wafer is airborne from one
processing step to the next.  Some of these systems also
employ pulsating air jets to align a wafer prior to
delivery to the work station where the wafer may be
exposed.  Descriptions of such systems are given in U.S.
Patent No. 4,165,132; 4,081,201 and 3,976,330 for example.

MI-3125
0129731

Such systems wherein wafers are transported and aligned by means of air by their nature stir up dust and other particles which have been found in many instances to contaminate the sensitized surfaces of the wafers beyond acceptable levels. Further, the inherent instability of air track wafer transport systems results in the constant collision of the periphery of the wafers against guide rails which results in damage to the sensitized top surface of the wafers.

Further, alignment by means of air jets may result in further damage to the wafer by constant vibration of the wafer in various orientations against the alignment platform. Such alignment also lacks the speed and effiency provided by secure mechanical means which grasp and align the wafers.

Also in this type of system, as well as other types, alignment of the wafers may be destroyed between alignment and delivery of the wafer to the work station.

The present invention overcomes the foregoing disadvantages and provides a unique combination for the safe and efficient handling of wafers.

BRIEF SUMMARY OF THE PRESENT INVENTION

The present invention relates to a wafer handling system for transporting wafers sequentially from an input cassette to an alignment station, a work station and a storage cassette. After alignment the wafer is delivered to the work station without disturbing its aligned condition.

More particularly the present invention employs an input shuttle which enters the input cassette, fixes to the bottom surface of the wafer and transports it to an alignment station.  At the alignment station the wafer
is raised from the shuttle, oriented in the X, Y and θ
directions, and lowered back onto the shuttle without
distrubing its alignment.  The shuttle then delivers the
wafer to the work station.  At the work station the wafer
is again raised and the input shuttle removed.  The wafer
is then deposited on a chuck without disturbing its
alignment and the work process such as exposure is
performed.  The wafer is then raised to permit an output
shuttle to fix itself to the wafer and deliver it to the
output or storage cassette.  Throughout a transport cycle
the wafer is contacted only on its unsensitized bottom
surface.  The cycle is repeated until all the wafers in
the input cassette have been processed.

## BRIEF DESCRIPTION OF THE DRAWINGS

Figure 1 is a pictorial view outlining the
general configuration of the present invention;

Figure 2 is a schematic view from above showing
the essential features of the present invention;

Figure 3 is a side view partly in section
showing the aligner of the present invention; and

Figures 4a and 4b are sectional views of the
chuck assembly of the present invention.

## DESCRIPTION OF THE INVENTION

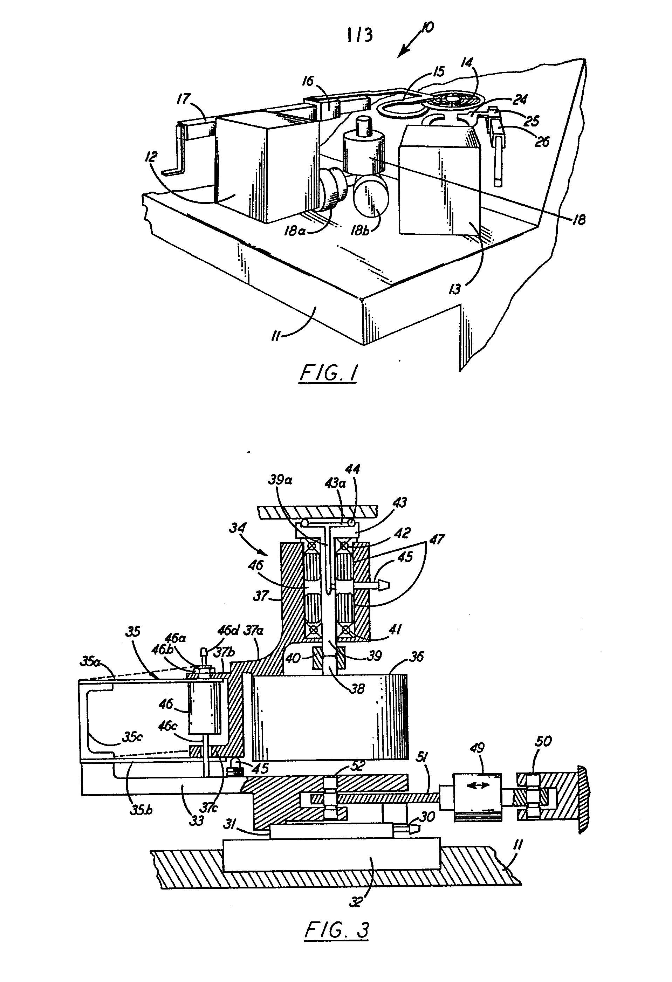

Figure 1 illustrates a typical embodiment of
the present invention.  The wafer handling system 10 of
the present invention is mounted, e.g., on a platform 11.
It comprises an input cassette 12 and an output cassette
13.  The cassettes 12 and 13 each are capable of storing a plurality of wafers one in each of a plurality of slots. The cassettes 12 and 13 are disposed such that their open ends face toward chuck assembly 14 at the work station. More precisely, the center lines of the cassettes 12 and 13 converge and meet at the center of chuck assembly 14.

An input shuttle 15 is fixed to a guide 16 which is slidably mounted on air bar 17. A pneumatic piston 18 is fixed to guide 16 for moving input shuttle 15 between input cassette 12 and chuck assembly 14.

An alignment assembly 18 is disposed in the path of input shuttle 15. The alignment assembly 18 includes three motors (only two of which 18a and 18b are shown in the Figure) for orienting a wafer in the X, Y and θ directions prior to delivery to the chuck assembly 14.

After the wafer is oriented shuttle 15 delivers it to chuck assembly 14 for processing. After processing, the wafer is retrieved by the output shuttle 24 and transported by means of guide 25 and air bar 26 to output cassette 14 for storage. This cycle is repeated until the wafers in input cassette 12 are exhausted. During the entire process the wafer is contacted only on its unsensitized bottom surface.

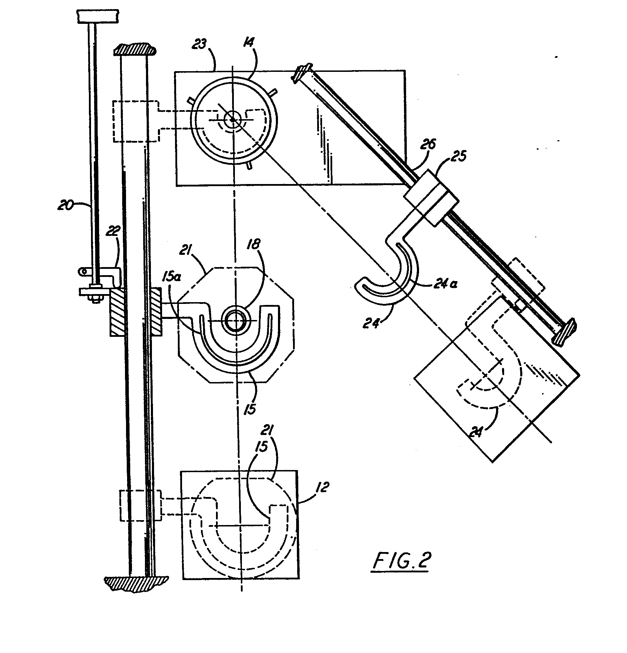

Figure 2 is a move detailed showing of the wafer handling system of the present invention.

The input cassette 12, aligner 18 and chuck assembly 14 at work station 19 are shown disposed in a path through which input shuttle 15 is transported by means of a guide 16 disposed on air bar 17. Air bar 17 may be of the Dover Air Bearing type wherein guide 16 rides on a film of air as it transports shuttle 15 along air bar 17. Air is injected into the guide 16 to form the film of air on which guide 16 rides. The airfilm which permits free precise motion between guide 16 and airbar 17 exists in a small gap between the guide 10 and airbar 17 through which air is constantly escaping.

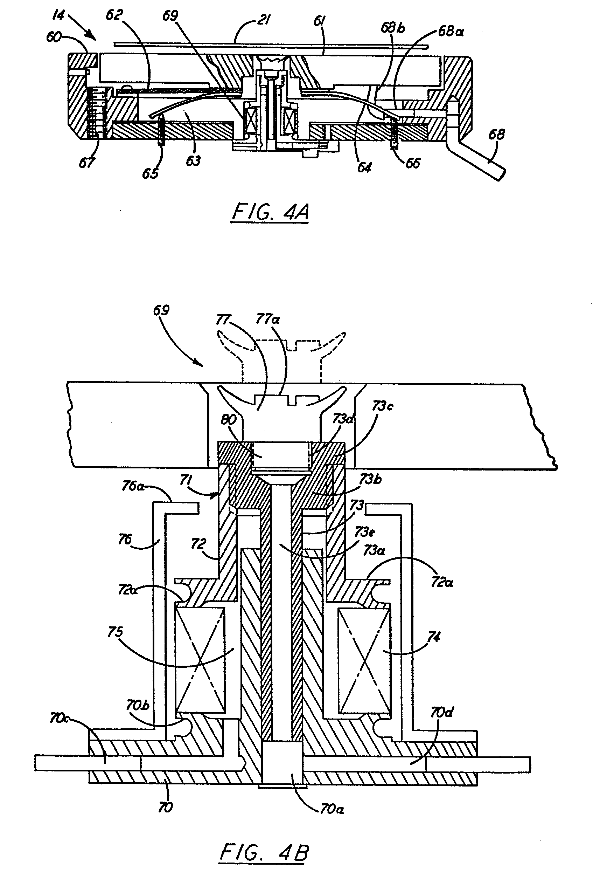

As can be seen in Figure 2 guide 16 and, therefore, input shuttle 15 are moved along air bar 17 by means of a piston 20. Piston 20 which is actuated by means not shown is fixed to guide 16 and initially causes shuttle 15 to be moved into input cassette 12. The shuttle 15 and a wafer 21 to be transported are shown in dashed lines within input cassette 12. The input cassette 12 is lowered causing the insensitized bottom surface to contact shuttle 15 which then has vacuum applied to it which via opening 15a causes shuttle 15 to firmly grasp the wafer 21. Piston 20 then moves guide 16 to aligner 18. A stop 22 stops guide 16 at the position where wafer 21 is positioned over aligner 18. Aligner 18 then lifts the wafer 21 off the shuttle 15, aligns it and lowers it back onto shuttle 15 for further transport. The vacuum to shuttle 15 is turned off prior to the wafer 21 being lifted off the shuttle 15 and back on before it is deposited back onto shuttle 15. The manner in which aligner 18 varies and lowers the wafer 21 is discussed more fully in reference to Figure 3.

After the wafer is aligned, stop 22 is moved out of the path of guide 16 and the shuttle 15 carries the wafer 21 to the work station 23 where another stop (not shown) causes the shuttle to stop over chuck assembly 14. The chuck assembly 14 includes means for lifting the wafer 21 off the shuttle 15 to allow shuttle 15 to be removed and transported back to input cassette 12 in readiness for the next wafer. Prior to lifting the wafer 21 off the shuttle 15 the vacuum to the shuttle 15 is removed.

Once the shuttle 15 is removed from the chuck assembly 14, the wafer 21 is lowered onto the chuck assembly where it is held by a vacuum during the process to be performed.

After the wafer 21 is processed, the vacuum is removed from the chuck assembly 14 and the wafer is again lifted off the chuck assembly 14 to permit output shuttle 24 to be positioned under it. The wafer is then lowered onto the output shuttle 24 and transported to output cassette 13 for storage. The output shuttle 24 is transported by means of guide 25 and air bar 26 in a manner similar to that described with respect to shuttle 15, guide 16 and air bar 17. Alternately, the output shuttle may be transported by a rodless piston without an airbar since precision is not necessarily required in placing the wafer in the output cassette.

The wafer 21 is deposited in output cassette 13 which is raised to lift the wafer from the shuttle 24. Shuttle 24 also has vacuum supplied to it which through slot 24a causes the wafer to be firmly attached to the shuttle during transport. The vacuum is shut off at appropriate times, e.g., when the wafer is deposited in output cassette and the time during which the shuttle 24 is returned to chuck assembly 14 to retrieve another wafer.

Figure 3 is a more detailed showing of aligner 18 of the present invention. The aligner 18 is mounted on platform 11 by means of an air bearing 31 and an air bearing surface 32 mounted in platform 11. Air bearing 31 has a conduit 30 for connecting a pressurized source of air to air bearing 31 to permit frictionless movement of the aligner 18, e.g., in the X and Y directions relative to platform 11.

The aligner assembly is supported on air bearing 31 by means of support assembly 33. Support assembly 33 in turn supports rotor assembly 34, flexure assembly 35 and stepper motor 36.

Rotor assembly 34 comprises housing 37. The stepper motor 36 which is fixed to and supported by extension 37a of housing 37 has a shaft 38 which is connected to a shaft 39 by flexible coupling 40. Flexible coupling 40 functions to relieve stress on the shaft that might occur when rotor housing 34 and rotor shaft 39 are misaligned. Bearings 41 and 42 are disposed around shaft 39 within housing 37. Fixed to the end of shaft 39 is rotor 43. Rotor 43 has a recess 43a with an O-ring 44 disposed therein. Shaft 39 has a conduit 39a which communicates with input conduit 45 via volume 46. Magnetic seals 47 maintain volume 46 airtight. Thus, when vacuum is applied to conduit 45, a wafer resting on rotor 43 is held securely. Rotor assembly 36 is adapted to be raised and lowered by flexure assembly 35 so that rotor 43 raises and lowers a wafer held thereon.

Flexure assembly 35 comprises flexures 35a and 35b which may be of any convenient material, e.g., stainless steel having the desired degree of elasticity.

One end of flexures 35a and 35b is fixed to a spacer 35c which is fixed to support assembly 33.

The other end of flexure 35a is fixed to a further extension 37b of housing 37. This connection is made at the input end of an airpot 46 by means of a threaded extension 46a which extends through bores in the flexure 35a and extension 37b. The airpot 46 which may be of the type manufactured by Airpot Corporation of Norwalk, Connecticut has a piston 46c which extends through openings in extension 37c and flexure 35b to be fixed to support assembly 33 in a convenient manner. The airpot 46 which is a cylinder-piston type arrangement has an input conduit 46d which on application of pressurized air thereto causes piston 46c to extend.

Thus, when air is applied at input conduit 46d the entire housing 37 is raised and along with it rotor assembly 34 and stepper motor 36 by the reaction of piston 46c against support assembly 33. Removal of air which can be done gradually causes the assembly to be lowered. Stop 47 fixed to support assembly 33 prevents flexure assembly 35 and, therefore, housing 37 from overshooting. The flexure assembly 35 and airpot 46 provides great stability to the housing 37 during raising and lowering and eliminates rotational movement of the housing 37 and, therefore, rotor assembly 34. Thus, when a wafer is fixed to rotor 43 it may be raised from input shuttle 15, aligned and then lowered back onto the shuttle 15 without disturbing the alignment. It should also be noted that only the unsensitized bottom of the wafer is touched.

Figure 3 also shows a motor 49 fixed at one end to mechanical ground by bearing means 50 and at the other end via rod 51 and yoke means 52 to support assembly 33. Motor 49 provides aligning movement in the X direction by extending or retracing rod 51 which moves air bearing 31 on air bearing surface 32 in the X-direction. Movement in the Y direction is obtained in an identical manner by a motor and rod connected to yoke means 52 (not shown). Movement in the θ direction is provided by stepper motor 36.

Alignment of the wafer may be accomplished in any conventional manner wherein the components for sensing alignment do not touch the wafer itself. Such a system may comprise light sensors and light sources positioned on opposite sides of the plane width occupied by the wafer during its raised and lowered position.

Figure 4a is a more detailed representation of chuck assembly 14. Chuck assembly 14 comprises housing 60. A platen 61 is disposed in a recess within housing 60 as shown. A suspension spring 62 fixed to housing 60 and platen 61 along with preload springs 63 and 64 acting against set screws 65 and 66, respectively causes the platen 62 to be spring loaded within housing 60. Further means (not shown) may be inserted through opening 67 to maintain platen centrally positioned if tilted or from stressing spring 62 inordinately if the chuck assembly is turned upside down.

A conduit 68 passes through housing 60 and is connected to platen 61 via conduit 68a and tube 68b to permit vacuum to be connected to platen 61. By means of a manifold and small openings in platen 61 which terminate at the surface of the platen 61 wafer 21 may be held fast to the platen 61.

A wafer lifter mechanism 69 is centrally located within chuck assembly 14.  The wafer lifter mechanism 69 is shown enlarged in Figure 4b.

As shown in Figure 4b wafer lifter mechanism 69 comprises a base 70 fixed to chuck assembly housing 60 by any convenient means.  Base 70 has a cylinder 70a formed therein.  Wafer lifter mechanism 69 also comprises a movable element 71.  Movable element 71 comprises a cylindrical housing 72 and a piston means 73.  Piston means 73 includes a shaft portion 73a slidably disposed in cylinder 70a and a first radially expanded portion 73b disposed in and fixed to the upper portion of cylindrical housing 72, e.g., by threads on the external diameter of portion 73b of piston means 73 and internal threads on the inner diameter of the upper portion of cylindrical housing 72.  Piston means 73 has a further expanded portion 73c which abuts the upper end of cylindrical housing 72.  The lower end of cylindrical housing 72 has an extension 72a fixed to one end of a metal bellows 74.  The other end of metal bellows 74 is fixed to base 70 at extension 70b.  Portion 73a of piston means 73, cylindrical housing 72, metal bellows 74 and base 70 forms and airtight seal of the volume 75.  Metal bellows 74 is a standard manufactured item avialable, e.g., from the Metal Bellows Co. of Rhode Island.  Metal bellows 74 normally spring biases movable element 71 in the position shown.  However, when movable element 71 is forced upward as is discussed below, metal bellows 74 expands appropriately in the longitudinal direction while maintaining the airtight character of the volume 75.  Metal bellows 74 has the function of maintaining stability of the movable element 71 and particularly prevents rotational movement thereof.  A limit stop 76 fixed at one end to base 70 has an extension 76a to limit the upward movement of movable element 71 by interaction with extension 72a of cylindrical housing 72.

A relatively solid element 80 is screwed into recess 73d of portion 73c of piston means 73. A flexible rubber cup 77 is attached to solid element 80. Rubber cup 77 and elements 80 and 73 have a common bore which connects to vacuum passage 70d to apply vacuum at the surface of flexible rubber cup 77.

A conduit 70d formed in base 70 communicates with cylinder 70a and the surface of flexible rubber cup 77 via conduit 70d and the ducts in element 76 and flexible rubber cup 77. Thus, when vacuum is applied to conduit 70d, a wafer in contact with flexible rubber cup 77 is sucked down and securely held by the flexible rubber cup 77. Flexible rubber cup 77 may also comprise stops 77a, (e.g., three stops) to prevent overflexure of the flexible rubber cup 77 when it secures a wafer.

When air pressure is applied to conduit 70c, it enters airtight volume 75 and forces movable elements 72 and 71 upward causing rubber cup 77 to assume the position shown in dashed lines in Figure 4b. In its upward movement rubber cup 77 now with vacuum applied grasps the wafer and lifts it off input shuttle 15 which is then removed. It is then slowly lowered to platen 61 by the spring action of metal bellows 74 by switching from the positive pressure needed to lift movable element 71 to atmosphere through a restrictor (not shown) in conduit 70c which allows the air to escape slowly. The rate of descent is controlled by the size of the restrictor. Once the piston is retracted to its home position, vacuum is applied to conduit 70c to assure vellows 74 is completely nested.

As aforesaid metal bellows 74 function to prevent rotational movement of movable element 71 and thus alignment of the wafer is preserved when it is deposited on the platen 61 for processing.

Vacuum is removed from rubber cup 77 and applied to platen 61 thus permitting a work process to be performed on the wafer in any appropriate position since the wafer is fixed to the platen 61 by vacuum.

When processing is finished, vacuum is removed from the platen 61 and the wafer is lifted off the platen by applying pressure to conduit 70c to again force movable element 71 upward with vacuum applied to rubber cup 77 to hold the wafer secure. This permits the wafer to be retrieved by output shuttle 24 and returned to output cassette 13 after vacuum is removed from conduit 70. The process is repeated for each wafer arriving at the work station 23.

Thus, there has been described a wafer handling apparatus for the alignment, processing of a wafer and its transport from an input cassette to an output cassette wherein the wafer is delivered and handled at the alignment and work stations without disturbing its alignment and without any of the handling equipment causing damage to the sensitized surface of the wafer or its edges.

Other modifications of the present invention are possible in light of the above description which should not be deemed as placing limitations on the invention other than those expressly set forth in the claims which follow:

MI-3136

0129731

WHAT IS CLAIMED IS:

1.  In a wafer handling system,

an alignment station,

first shuttle means for transporting a wafer to said alignment station,

said alignment station including first elevator means for raising the wafer from said shuttle means prior to alignment and depositing it on said shuttle means after alignment without disturbing its alignment.

2.  In a wafer handling system according to Claim 1 further including,

a work station including chuck assembly means,

said first shuttle means transporting the wafer to said work station,

said chuck assembly means including a platen and second elevator means for raising the wafer from said first shuttle means and depositing it on said platen without disturbing its alignment.

3.  In a wafer handling system according to Claim 2 further including,

means for removing said first shuttle means from said work station while the wafer is in the raised condition prior to its deposition on said platen,

- 14 -     MI-3136

0129731

second shuttle means,

said second elevator means raising the wafer from said platen to permit its retrieval by said second shuttle means.

4.  In a wafer handling system according to Claim 3 wherein,

said first and second shuttle means and said first and second elevator means contact only the bottom of the wafer during handling.

5.  In a wafer handling system according to Claim 3 wherein said alignment station includes means for moving the wafer in the X, Y and θ directions while it is in the raised condition.

6.  In a wafer handling system according to Claim 4 wherein said alignment station includes means for moving the wafer in the X, Y and θ directions while it is in the raised condition.

7.  In a wafer handling system according to Claim 1 wherein said first elevator means comprises,

rotor assembly means,

flexure means connected to said motor assembly means for raising and lowering said rotor assembly means without changing its rotational orientation.

8.  In a wafer handling system according to Claim 7 wherein said rotor assembly comprises,

**0129731**

rotor means having a surface adapted to support a wafer,

shaft means connected at one end to said rotor,

housing means enclosing said shaft

9. In a wafer handling system according to Claim 8 further including,

motor means connected to the other end of said shaft means for moving said rotor means in the $\theta$ direction,

said rotor means being fixed to said housing.

10. In a wafer handling system according to Claim 9 wherein said flexure means comprises,

first and second spaced apart flexible elements fixed at one of each of their ends to said housing means,

airpot means disposed between said one ends of said flexible elements for raising and lowering said rotor assembly.

11. In a wafer handling system according to Claim 10 further including,

support means for supporting said housing means,

second and third motor means connected to said housing means for translating said housing means in the X and Y directions.

12. In a wafer handling system according to Claim 11 wherein said airpot means comprises,

an airtight housing enclosing a cylinder,

a piston disposed in said cylinder and extending from one end of said housing,

said piston fixed to said support means,

an input conduit connected to the other end of said airtight housing for introducing and exhausting air from said cylinder for extending and retracting said piston,

said other end of said airtight housing being fixed to one of said first and second flexible elements.

13. In a wafer handling system according to Claim 12 further including,

conduit means for introducing vacuum to said surface of said rotor means for securing a wafer to said rotor means.

14. A wafer aligner for aligning a wafer in the X, Y and θ directions comprising,

rotor assembly means,

flexure means connected to said rotor assembly means for raising said rotor assembly means prior to alignment and lowering said rotor assembly means after alignment without changing its rotational orientation.

MI-3136

0129731

15.   A wafer aligner according to Claim 14 wherein said rotor assembly means comprises,

rotor means having a surface adapted to support a wafer,

shaft means connected at one end to said rotor,

housing means enclosing said shaft.

FIG. 1

FIG. 3

_FIG.2_

3/3

*FIG. 4A*

*FIG. 4B*

0129731

Application number

EP 84 10 6071

European Patent
Office

**EUROPEAN SEARCH REPORT**

## DOCUMENTS CONSIDERED TO BE RELEVANT

| Category | Citation of document with indication, where appropriate, of relevant passages | Relevant to claim | CLASSIFICATION OF THE APPLICATION (Int. Cl. 3) |
|---|---|---|---|
| A | US-A-3 823 836 (PLAT-GENERAL) <br> * column 3, lines 28-54; figures 1-3 * | 1,4 | H 05 K 13/00 <br> H 05 K 13/02 |
| | --- | | |
| A | US-A-3 865 254 (KASKER) <br> * column 6, lines 20-40; figures 1,2,6 * | 1 | |
| | --- | | |
| A | US-A-3 820 647 (TEXAS INSTR.) <br> *. column 2, lines 45-60; figure 2 * | 1 | |
| | --- | | |
| A | FR-A-1 571 147 (PASTUKHOV) <br> * page 4, lines 2-13; figure 3 * | 1,5,6 | |
| | --- | | |
| A | US-A-4 068 947 (PERKIN-ELMER) <br><br> * column 9, lines 47-62; figure 12 * | 1,5,6, 11 | TECHNICAL FIELDS SEARCHED (Int. Cl. 3) <br><br> H 05 K |
| | ----- | | |

The present search report has been drawn up for all claims

| Place of search | Date of completion of the search | Examiner |
|---|---|---|
| THE HAGUE | 25-09-1984 | LOMMEL A. |